# EUROPÄISCHE PATENTSCHRIFT

(11) **EP 0 958 719 B1**
(45) Veröffentlichungstag und Bekanntmachung des Hinweises auf die Patenterteilung: **22.05.2002**
(21) Anmeldenummer: 97914119.9
(22) Anmeldetag: 03.02.1997
(51) Int. Cl.: H05K 7/14

(54) **FRONTSYSTEM FÜR LEITERPLATTEN IN BAUGRUPPENTRÄGERN MIT VERRASTBAREM HEBELZIEHGRIFF**
FRONTAL SYSTEM FOR PRINTED CIRCUIT BOARDS IN MODULE CARRIERS WITH LOCKABLE LEVER PULL HANDLES
SYSTEME FRONTAL POUR CARTES DE CIRCUITS DANS DES SUPPORTS DE BLOCS DE COMPOSANTS, A MANETTE DE TIRAGE DE LEVIER ENCLIQUETABLE

(43) Veröffentlichungstag der Anmeldung: 24.11.1999
(73) Patentinhaber: RITTAL Electronic Systems GmbH & Co. KG, 35745 Herborn (DE)
(72) Erfinder: BILLENSTEIN, Ernst, D-91593 Burgbernheim (DE); KÖRBER, Werner, D-91282 Betzenstein (DE); SCHAFFER, Kurt-Michael, D-90542 Eckental (DE)
(74) Vertreter: Jeck, Anton, Dipl.-Ing.
(86) Internationale Anmeldenummer: DE9700212
(87) Internationale Veröffentlichungsnummer: WO9834449

(56) Entgegenhaltungen:
- EP-A- 0 129 883
- EP-A- 0 194 515
- US-A- 4 233 646
- US-A- 5 414 594

## Beschreibung

Aus der Patentschrift US 4,233,646 ist ein Hebelziehgriff für gedruckte Leiterplatten bekannt. Im Bereich eines unteren Drehpunktes ist ein maulschlüsselartiger Eingriffsbereich vorhanden. Über diesen kann bei einer Betätigung des Hebels eine Ein- bzw. Aushebelung einer Leiterplatte in bzw. aus einem Baugruppenträger bewirkt werden. Oberhalb des Drehpunktes weist der Griff einen langgestreckten Hebelbereich auf, welcher in einem Griffstück endet. Am Übergang zwischen Hebelbereich und Griffstück befindet sich ein hakenförmiger Bereich. Hiermit kann der Hebel an einem auf der Leiterplatte angeordneten Stift arretiert werden, so daß der Hebelziehgriff annahernd parallel an der Vorderkante der Leiterplatte anliegt.

Eine derartige Anordnung weist den folgenden Nachteil auf. Befindet sich z.B. die Leiterplatte in einem vollständig in den Baugruppenträger eingeschobenen Zustand und soll diese beispielhaft aus dem Baugruppenträger ausgehebelt werden, so muß ein Bediener zunächst durch Krafteinwirkung den Hebel aus der Arretierposition bewegen. Dies hat zur Folge, daß der hakenförmige Bereich von Stift getrennt wird und der Hebel so um den Drehpunkt schwenkbar ist, daß der maulschlüsselartige Eingriffsbereich mit dem Baugruppenträger in Kontakt treten kann. Erst jetzt ist es für einen Bediener durch Ausübung einer weiteren Krafteinwirkung auf das Griffstück möglich, die Aushebelung der Baugruppe aus dem Baugruppenträger zu bewirken. Dabei tritt das Problem auf, daß die beiden aufeinander folgenden Krafteinwirkungsvorgänge für einen Bediener nicht sicher voneinander trennbar sind. Vielmehr besteht die Gefahr, daß die Entriegelung des Hebelziehgriffes durch den ersten Krafteinwirkungsvorgang direkt in den Aushebelvorgang der gesamten Leiterplatte aus dem Baugruppenträger übergeht. Dies ist in der Praxis zunehmend unerwünscht. Während die Entriegelung des Hebelziehgriffes aus der Arretierposition eine einfache Vorbereitungshandlung darstellt, ist die komplette Aushebelung einer Leiterplatte eines in vielen Fällen aus einer Vielzahl von Leiterplatten bestehenden elektrischen Gesamtsystems aus einem Baugruppenträger ein drastischer Eingriff. Zur Vorbereitung hierzu sind von Seiten eines Bedieners unter Umständen weitere, andersartige Maßnahmen auszuführen, z.B. im einfachsten Falle die Unterbrechung von Spannungsversorgungen. Aus diesem Grund ist ein versehentlicher, quasi gleitender Übergang zwischen der einfachen Entriegelung eines Hebelziehgriffes an der Frontseite einer Leiterplatte und dem eigentlichen Aushebelvorgang der Leiterplatte aus dem Baugruppenträger z.B. aus Sicherheitsgründen unerwünscht.

Aus der Europäischen Patentschrift EP 0 129 883 B1 ist eine weitere Ausführung eines Hebelziehgriffes bekannt, welcher der in der US 4,233,646 beschriebenen Art entspricht. Dabei entspringt an der Vorderseite des Griffstückes des dortigen Winkelhebels eine auf die Frontleiste der Flachbaugruppe gerichtet Blattfeder, welche am Ende eine Rastnase trägt. Diese kann zur Arretierung des Hebels in eine fensterartige Öffnung in der Frontleiste eingerastet werden. Zur Entriegelung der Hebels aus dieser Arretierposition muß ein Bediener durch Kraftausübung auf das Griffstück die Blattfeder eindrücken und gleichzeitig den Hebel schwenken. Dies ist zum einen nur erheblichem Kraftaufwand möglich, zum anderen tritt auch hier das bereits an Hand der US 4,233,646 beschriebene Problem der mangelhaften Entkopplung des einleitenden Vorganges der Hebelentriegelung und des Hauptvorganges der Aushebelung der gesamten Leiterplatte auf.

Aus der Europäischen Patentschrift EP 0 194 515 B1 ist eine weitere Ausführung eines Hebelziehgriffes bekannt, welche ebenfalls prinzipiell der in der US 4,233,646 und der EP 0 129 883 B1 beschriebenen Bauform entspricht. Auch hier kann der Hebel über ein Rastnase einer Blattfeder in einer an der Oberfläche der Frontplatte eine Flachbaugruppe möglichst anliegenden Position arretiert werden. Im Inneren des Hebelziehgriffes ist zusätzlich eine Spiralfeder gelagert. Diese übt eine derartige Vorspannung auf den gesamten, drehbar gelagerten Hebel aus, daß dieser möglichst in Richtung auf die Arretierposition geschwenkt ist bzw. auf diese gerichtet selbsttätig zurückschnappt.

Der Erfindung liegt die Aufgabe zugrunde, ein Frontsystem anzugeben, bei dem die dazugehörigen Hebelziehgriffe zum einen leichter bedienbar sind und desweiteren die Vorgänge der Hebelentriegelung und der Leiterplattenaushebelung besser entkoppelt sind.

Die Aufgabe wird gelöst mit dem im Anspruch 1 angegebenen Frontsystem für elektrische Leiterplatten. Weitere, vorteilhafte Ausführungsformen der Erfindung sind in den Unteransprüchen angegeben.

Die Erfindung wird an Hand von in den nachfolgend kurz angeführten Figuren dargestellten Ausführungsbeispielen näher erläutert. Dabei zeigt
- FIG 1 :: eine perspektivische Ansicht auf die Rückseite einer bevorzugte Ausführung des erfindungsgemäßen Frontsystems, wobei ein Hebelziehgriff vorteilhaft an einem unteren bzw. oberen Endstück eines Frontelements angebracht ist,
- FIG 2 :: eine perspektivische Seitenansicht auf eine bevorzugt Ausführungsform eines in einem Hebelziehgriff gelagerten Rastschiebers,
- FIG 3 :: einen perspektivische Frontansicht auf die bevorzugte Ausführungsform des Hebelziehgriffes des erfindungsgemäßen Frontsystems gemäß Figur 1,
- FIG 4 :: eine Ausschnittdarstellung durch einen Teil eines Hebelziehgriffs gemäß den Ausführungen der vorangegangenen Figuren, wobei die Details einer bevorzugten Ausführung einer Spiralfeder der Spannmittel des Frontsystems vergrößert dargestellt sind,
- FIG 5 :: eine Schnittdarstellung durch einen am unteren Ende des Frontsystems einer Leiterplatte angebrachten Hebelziehgriff, wobei der Hebelziehgriff sich in einer Verriegelungsstellung und die Leiterplatte in dem vollständig in den Baugruppenträger eingeschobenen Zustand befindet,
- FIG 6 :: eine Schnittdarstellung durch einen am unteren Ende des Frontsystems einer Leiterplatte angebrachten Hebelziehgriff, wobei der Hebelziehgriff sich in einer entriegelten Stellung und die Leiterplatte in dem noch vollständig in den Baugruppenträger eingeschobenen Zustand befindet, und
- FIG 7 :: eine Schnittdarstellung durch einen am unteren Ende des Frontsystems einer Leiterplatte angebrachten Hebelziehgriff, wobei der Hebelziehgriff sich in einer entriegelten Stellung und die Leiterplatte in dem aus dem Baugruppenträger ausgeschobenen Zustand befindet.

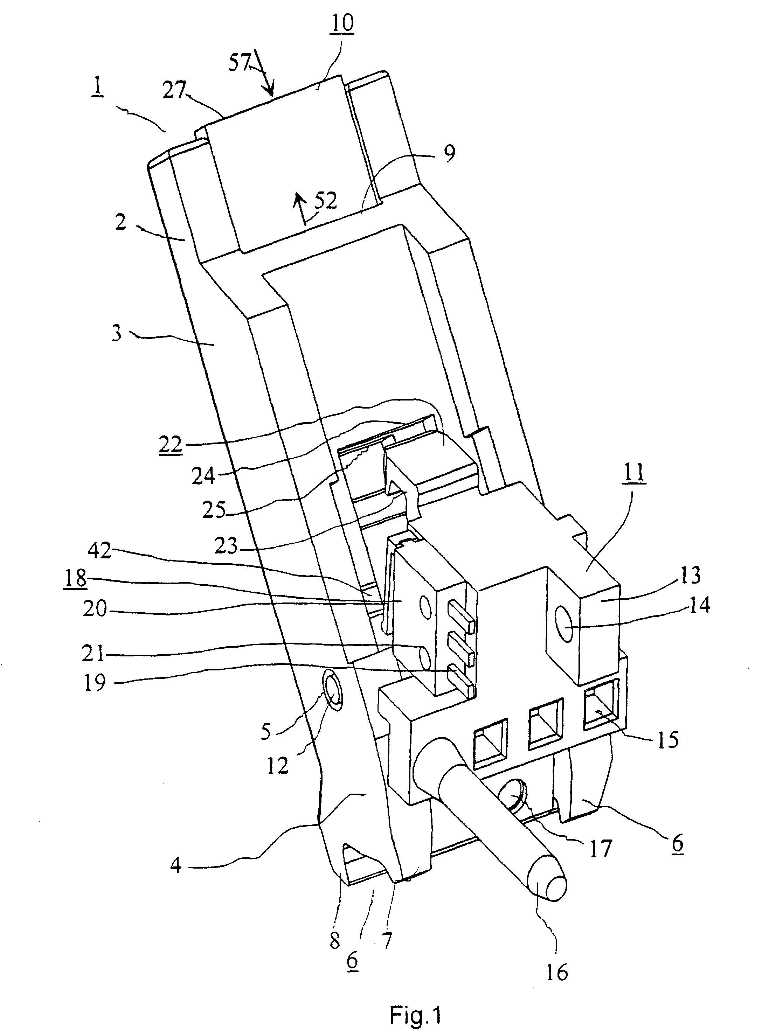

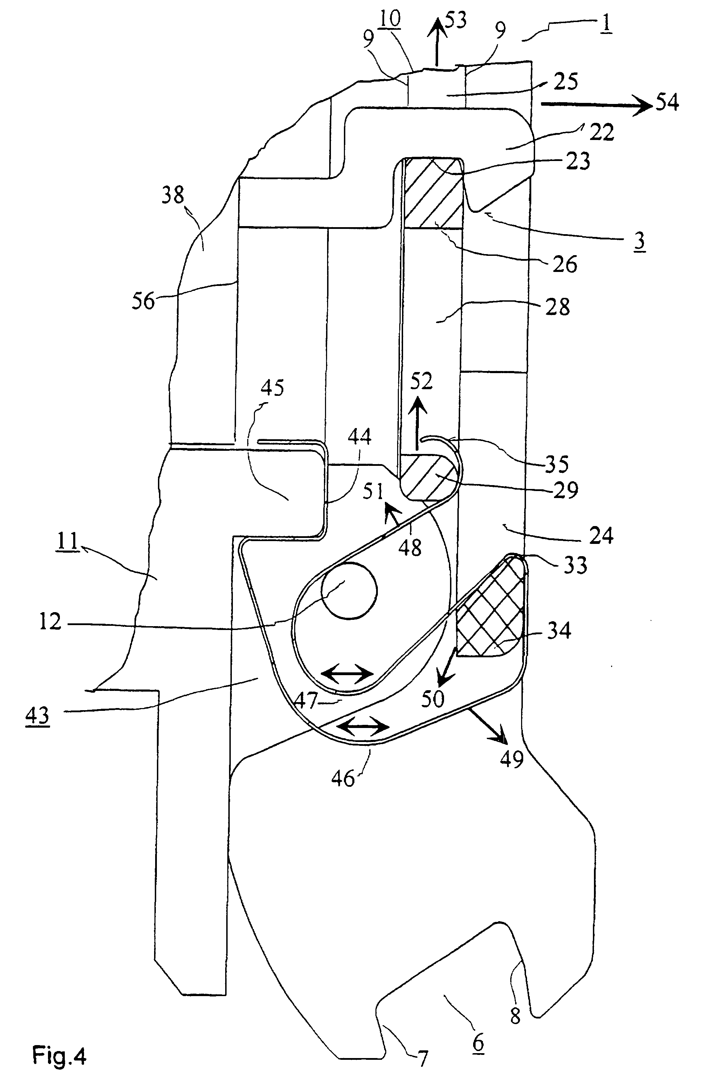

Bei der in Figur 1 dargestellten perspektivische Ansicht ist die Rückseite einer bevorzugten Ausführung eines gemäß der Erfindung ausgeführten Frontsystems dargestellt. Der Hebelziehgriff 1 weist dabei einen langgestreckten, ersten Hebelarm 3 auf, der vom Griffbereich 2 des Hebelziehgriffes 1 bis zu einer Durchgriffsbohrung 5 reicht. Die Durchgriffsbohrung 5 wird von einem Lagerzapfen 12 durchsetzt, welcher als Drehpunkt für den Hebelziehgriff 1 dient. Von der Durchgriffsbohrung 5 erstreckt sich schließlich ein zweiter kurzer Hebelarm 4, welcher in einem bevorzugt maulschlüsselartigen Eingriffsbereich 6 endet. Dieser weist zumindest eine sogenannte Einhebelkante 7 und zumindest eine Aushebelkante 8 auf. Diese Kanten stützen sich bei einer auf den Baugruppenträger gerichteten, und die Einhebelung einer Baugruppe bzw. bei einer vom Baugruppenträger weggerichteten, die Aushebelung einer Baugruppe bewirkenden Schwenkung des Hebelziehgriffes 1 um den Drehpunkt 12 am Baugruppenträger ab. Bevorzugt stützen sich die Ein- und Aushebelkante 7,8 eines maulschlüsselartigen Eingriffsbereiches 6 an einer oberen bzw. unteren Querschiene des Baugruppenträgers ab. In den folgenden Figuren 4 bis 7 ist im Querschnitt beispielhaft eine untere Querschiene 39 eines Baugruppenträgers 55 dargestellt. Diese weist eine vorstehende Abstützleiste 40 auf, welche in Querrichtung mit einer Reihe von Eingriffsöffnungen 41 versehen ist.

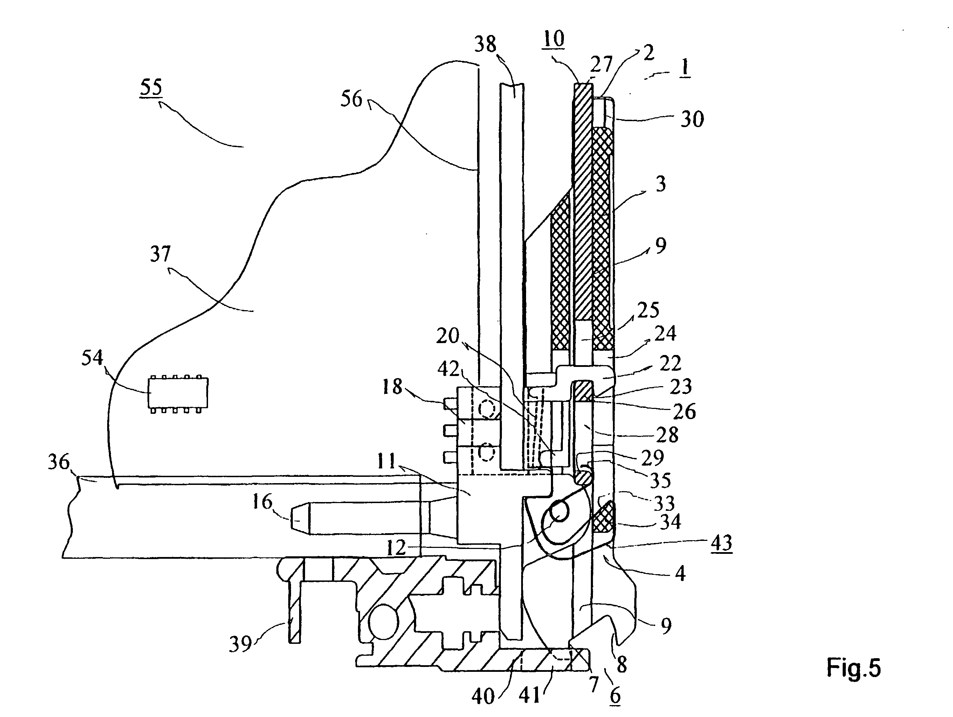

Bei einer Einhebelung einer Leiterplatte in den Baugruppenträger stützt sich die Einhebelkante 7 auf einer Innenflanke der räumlich zugeordneten Eingriffsöffnung 41 ab. Dies ist im Beispiel der Figur 4 dargestellt, welche den vollständig in den Baugruppenträger eingehebelten Zustand einer Leiterplatte 37 zeigt. In diesem Fall sind nicht dargestellte Steckerleisten der Leiterplatte 37 in elektrischem Kontakt mit entsprechenden Steckgegenleisten, welche im Inneren des Baugruppenträgers angeordnet sind. Andererseits stützt sich die Aushebelkante 8 auf der äußeren Stirnseite der Abstützleiste 40 ab. Ein derartiger Zustand ist im Beispiel der Figur 5 dargestellt, welche den Beginn der Aushebelung der Leiterplatte 37 aus dem Baugruppenträger 55 zeigt, in dem durch Krafteinwirkung auf den oberen Griffbereich 2 des Hebelziehgriffes 1 dieser von der Stirnseite 56 der Leiterplatte 37 weggeschwenkt wird.

Der in Figur 1 dargestellte, beispielhaft untere Hebelziehgriff 1 des Frontsystems einer Baugruppe ist bevorzugt an einem sogenannten Frontelement des Frontsystems drehbar gelagert. Das Frontelement wiederum ist an der frontseitigen Stirnseite 56 einer Leiterplatte 37 angebracht. Ein Frontelement enthält bevorzugt eine sogenannte Frontplatte 38, welche die Stirnseite 56 der Leiterplatte 37 abdeckt und in den Schnittdarstellungen der Figuren 4 bis 6 dargestellt ist. Ferner weist ein Frontelement bevorzugt je ein Endstück auf, welches am unteren und oberen Ende der Frontplatte 38 angebracht ist und worüber die Frontplatte 38 mit der Leiterplatte 37 verbunden ist. Bei den in den Figuren dargestellten Ansichten ist beispielhaft jeweils ein unteres Endstück 11 dargestellt. Gemäß der Darstellung in Figur 1 weist ein derartiges Endstück 11 vorteilhaft einen vorspringenden Halteblock 13 mit eines Bohrung 14 auf, worüber beispielhaft der Halteblock 11 an der unteren Kante einer Leiterplatte befestigbar ist.

Ferner sind an einer dem Baugruppenträger zugewandten Stirnseite des Halteblockes beispielhaft ein Führungsstift 16 vorhanden. Dieser taucht meist bereits zu Beginn eines Einhebelvorganges einer Leiterplatte in eine entsprechende Öffnung im Baugruppenträger ein, und verhindert ein seitliches Ausweichen der Leiterplatte. Ferner sind an dieser Stirnseite des Halteblockes 11 Kodierkammern 15 zum Einstecken von Kodierstiften vorhanden. Schließlich kann der Halteblock 11 über eine durch die Bohrung 17 reichende Halteschraube im vollständig eingesteckten Zustand am Baugruppenträger fest arretiert werden. Ein dem in Figur 1 dargestellten Halteblock 11 entsprechender Halteblock ist an dem in der Figur 1 aus Gründen der besseren Übersicht nicht gezeigten oberen Ende einer Leiterplatte angebracht. Wie bereits in Figur 1 dargestellt, ist der beispielhaft untere Hebelziehgriff 1 eines Frontsystems über einen Lagerzapfen 12 bevorzugt direkt am entsprechenden Endstück 11 drehbar gelagert. Figur 1 zeigt den Hebelziehgriff 1 und das dazugehörige Endstück 11 in einer perspektivischen Rückansicht, wobei der Hebelziehgriff 1 sich in einer abgeschwenkten Position befindet und aus Gründen der besseren Übersicht die dazugehörige Leiterplatte und die Frontplatte des Frontelements nicht dargestellt sind.

Erfindungsgemäß ist in einem Hebelziehgriff 1 ein Rastschieber 10 gelagert. Dieser weist einen bevorzugt kantenförmigen Druckbereich 27 auf, welcher an demjenigen Ende des Hebelziehgriffes 1, der den Griffbereich 2 bildet und der dem Eingriffsbereich 6 gegenüberliegt, zur Bedienung durch eine Person zugänglich ist. Vorteilhaft ist der Rastschieber 10 in einem Führungskanal 9 im Inneren des Hebelziehgriffes 1 gelagert. Bei der in Figur 1 dargestellten Ausführung weist der Griffbereich 2 des Hebelziehgriffes 1 eine geringere Tiefe auf als der Bereich des langen Hebelarmes 3. Hierdurch wird die Bedienbarkeit des Griffbereiches durch eine Person erleichtert. Es ist in einem solchen Fall vorteilhaft, wenn der Führungskanal 9 für den Rastschieber 10 nur im Bereich des langen Hebelarmes 3 verlauft. Das den Druckbereich 27 des Rastschiebers 10 bildende Ende ist dann im Griffbereich 2 des Hebelziehgriffes 1 frei zugänglich und z.B. von einer Bedienperson z.B. mit dem Zeigefinger gut erreichbar.

Das erfindungsgemäße Frontsystem enthält weiter sogenannte Spannmittel. Diese üben eine auf den Druckbereich 27 gerichtete Vorspannung auf den Rastschieber 10 aus, so daß dieser in der in Figur 1 dargestellten Ausgangsposition gehalten wird. Die Richtung der Vorspannung ist in Figur 1 mittels eines Druckrichtungspfeiles 52 symbolisiert. Durch eine, in Richtung auf den weiteren Druckrichtungspfeil 57 von einer Person z.B. mit einem Finger auf die Druckkante 27 ausgeübte Druckkraft kann der Rastschieber aus einer Ausgangsposition bewegt werden. Hierdurch können Rastmittel entriegelt werden. Dies wird nachfolgend näher beschrieben.

Erfindungsgemäß sind desweiteren Rastmittel vorhanden sind, welche an der oberen bzw. unteren Ecke des Frontelements angeordnet sind. Bei einer auf das Frontelement der Leiterplatte 37 gerichteten Schwenkung des Hebelziehgriffes 1 greifen diese so auf den Rastschieber 10, die Spannmittel und das Frontelement ein, daß der Hebelziehgriff 1 möglichst am Frontelement anliegend in einer Verriegelungsstellung gehalten wird. Eine derartige Verriegelungsstellung ist in Figur 4 beispielhaft dargestellt. Andererseits sind die Rastmittel, wie bereits beschrieben, durch eine auf den Druckbereich 27 des Rastschiebers 10 des Hebelziehgriffes 1 ausgeübte und gegen die Vorspannung 52 der Spannmittel gerichtete Verschiebung des Rastschiebers 10 wieder entriegelbar sind. Im Beispiel der Figuren 1 und 4 muß hierzu der Rastschieber von einer Bedienperson nach unten in den Führungskanal 9 und damit in den langen Hebelarm 3 hineingedrückt werden.

Das erfindungsgemäße Frontsystem weist den Vorteil auf, daß der dazugehörige Hebelziehgriff von einer Bedienperson ohne großen Kraftaufwand und in einer ergonomisch günstigen Weise bedienbar ist. Insbesondere ist die Entriegelung des Hebelziehgriffes, d.h. die Lösung von dessen Rastmitteln auf einfache Weise möglich. Diese Entriegelung ist somit kraftmäßig nahezu vollständig entkoppelt von dem weiteren Vorgang der vollständigen Aushebelung der Leiterplatte aus dem Baugruppenträger. Während eine Person eine Entriegelung des Hebelziehgriffes durch Betätigung der Druckkante des Rastschiebers mit Hilfe eines Fingers erreichen kann, muß diese Person für die Aushebelung der Leiterplatte eine erheblich größeren Kraft auf den Hebelarm aufbringen. Hierzu ist es in alle Regel notwendig, daß diese Person den Griffbereich 2 des entriegelten Hebelziehgriffes, der sich in diesem Zustand gemäß der Darstellung in Figur 5 vorteilhaft bereits in einer leicht von der Frontplatte abgeschwenkten Position befindet, mit mehreren Fingern oder der ganzen Hand vollständig umgreift. Eine Person muß also für die Entriegelung des Hebelziehgriffes und für die vollständige Aushebelung einer Leiterplatte zwei unterschiedliche Griffweisen auf den Hebelziehgriff ausüben. Ein versehentlich gleitender Übergang zwischen der vorbereitenden Hebelentriegelung und der eigentlichen Leiterplattenaushebelung ist somit nahezu ausgeschlossen.

Diese Eigenschaften des erfindungsgemäßen Frontsystems werden weiter begünstigt, wenn gemäß einer weiteren, und in den Figuren 1 bis 7 bereits dargestellten Ausführungsform der Erfindung, der Hebelziehgriff 1 derart gestreckt gestaltet ist, daß dieser in der Verriegelungsstellung der Rastmittel annähernd parallel zum Frontelement der Leiterplatte verläuft und an dieser möglichst flach anliegt. Besonders vorteilhaft ist es, wenn der Griffbereich 2 am Kopfende des Hebelziehgriffes 1, der lange Hebelarm 3, der kurze Hebelarm 4 und der insbesondere maulschlüsselartige Eingriffsbereich 6 am Fußende des Hebelziehgriffes annähernd in einer Ebene liegen. In einem solchen Fall weist der Hebelziehgriff keinerlei Vorsprünge auf und liegt in der verrasteten Position nahezu vollständig flach auf der Frontplatte des Frontelements einer Leiterplatte an. Vorteilhaft ist dann der Rastschieber 10 im geradlinig gestreckten, ersten langen Hebelarm 3 gelagert und die am Ende des Hebelziehgriffes 1 auf den Druckbereich 27 des Rastschiebers 10 in Richtung auf den Pfeil 57 aufgebrachten Entriegelungskräfte verlaufen nahezu vollständig in der Achse des Hebelziehgriffes und nahezu ideal parallel zum Frontelement der Leiterplatte. Diese Kräfte sind somit entkoppelt von den Kräften, welche zur Aushebelung einer Leiterplatte durch eine von der Frontplatte weggerichteten Schwenkung auf den Hebelziehgriff ausgeübt werden müssen.

Gemäß einer weiteren Ausführungsform weisen die Rastmittel vorteilhaft einen Rasthaken 22 auf, welcher derart ausgebildet ist, daß mittels der durch die Spannmittel auf den Rastschieber 10 ausgeübten Vorspannung 52 der Rastschieber 10 und das Frontelement so miteinander in Eingriff kommen, daß der Hebelziehgriff 1 in der Verriegelungsposition gehalten wird.

Bei der in den Figuren dargestellten, bevorzugten Ausführungsform der Erfindung sind die Rastmittel insbesondere in Form eines Rasthakens 22 direkt mit dem Endstück 11 am jeweiligen Ende der Frontplatte 38 verbunden. So entspringt in der Darstellung z.B. der Figur 1 vom Körper des Endstücks 11 in Richtung auf den drehbar gelagerten Hebelziehgriff 1 ein Rasthaken 22. Dessen nach unten gerichtete Rastnut 23 kommt nun im senkrecht stehenden Zustand des Hebelziehgriffes 1 mit dem Rastschieber 10 derart in Eingriff, daß auf Grund der in Richtung auf den Druckpfeil 52 auf den Rastschieber 10 gerichteten Vorspannung eine Verklemmung des Rastschiebers 10 in der Rastnut 23 des Rasthakens 22 auftritt. Auf diese Weise kann der Hebelziehgriff in der Verriegelungsstellung nahezu senkrecht stehend und möglichst an der Stirnkante der Leiterplatte anliegend gehalten werden. Die Verklemmung kann durch eine in Richtung auf den Druckpfeil 57 auf den Rastschieber 10 ausgeübte Druckkraft wieder gelöst werden. Hierbei kann der Rastschieber 10 aus der Rastnut des Rasthakens gelöst und der Hebelziehgriff nach vorne aus der Verriegelungsstellung herausgeschwenkt werden.

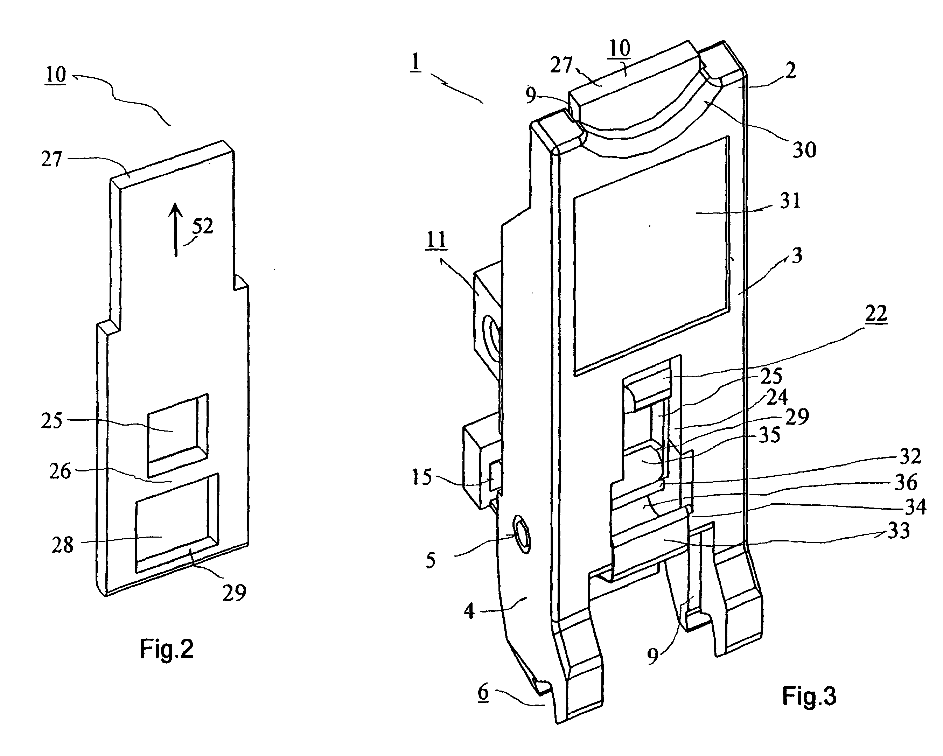

In Figur 2 ist eine perspektivische Seitenansicht auf eine bevorzugte Ausführungsform eines in einem Hebelziehgriff gelagerten Rastschiebers 10 dargestellt. Der Rastschieber weist dabei annähernd die Form einer flachen, gestreckten Platte auf. Vorteilhaft weist der Rastschieber 10 zusätzlich zumindest eine Durchgriffsöffnung 25 auf, bei der ein Wandungsbereich 26 mittels der durch die Spannmittel in Richtung des Druckpfeiles 52 auf den Rastschieber ausgeübten Vorspannung mit den insbesondere in Form eines nach unten gerichteten Rasthakens 22 ausgeführten Rastmitteln in Eingriff kommt. Die Seitenwandung 26 der Durchgriffsöffnung 25 wird folglich so in die Rastnut 23 gedrückt, daß der Hebelziehgriff annähernd senkrecht stehend in der Verraststellung gehalten wird. Dies ist an der Schnittdarstellung von Figur 4 zu erkennen.

Es ist vorteilhaft, wenn gemäß der Darstellung von Figur 2 der Rastschieber 10 eine zweite Durchgriffsöffnung 28 aufweist, welche von einem unteren Haltesteg 29 begrenzt wird. Mittels dieser Durchgriffsöffnung 28 können die Spannmittel auf einfache Weise auf den Rastschieber 10 einwirken und die in der Richtung des Pfeils 52 orientierte Vorspannung auf den Rastschieber ausüben. Besonders vorteilhaft ist es, wenn die Spannmittel eine Spiralfeder 43 aufweisen. Eine bevorzugte Ausführungsform einer derartigen Spiralfeder wird nachfolgend an Hand der Figuren 4 bis 7 noch näher erläutert werden. Vorteilhaft weist eine derartige Spiralfeder zumindest einen ersten Spannbogen 47 auf, wodurch die auf den Druckbereich 27 des Rastschiebers 10 gerichtete Vorspannung 52 ausgeübt werden kann. Dabei stützt sich der erste Spannbogen 47 einerseits am Frontelement ab, während eine Druckschlaufe 35 am anderen Ende des Federkörpers insbesondere drückend auf den zweiten Haltesteg 29 an der Unterkante der zweiten Durchgriffsöffnung 28 des Rastschiebers 10 einwirkt.

Dies ist an der in Figur 3 dargestellten perspektivischen Frontansicht auf die der Figur 1 entsprechende, bevorzugte Ausführungsform des Hebelziehgriffes des erfindungsgemäßen Frontsystems erkennbar. Der im Führungskanal 9 liegende Führungsschieber 10 wird durch die von der Druckschlaufe 35 der bevorzugt spiralfederförmigen Spannmittel, welche den Steg 29 am unteren Ende der Durchgriffsöffnung 25 umfaßt, nach oben in Richtung auf den Griffbereich 2 des Hebelziehgriffes 1 gedrückt. Zur Erleichterung der Eingriffe sowohl der bevorzugt rasthakenförmigen Rastmittel 22 als auch der bevorzugt spiralfederförmigen Spannmittel 43 weist der Körper des Hebelziehgriffes insbesondere im Bereich von dessen langem Schenkel 3 ein die in Figur 3 sichtbare Vorderseite durchsetzende Durchgriffsöffnung auf.

Die in Figur 3 dargestellte Ausführung eines Hebelziehgriffes 1 des erfindungsgemäßen Frontsystems weist an dem als Griffbereich 2 dienenden Ende zusätzlich eine bevorzugt halbmondförmige Griffmulde 30 auf. Diese hat den Vorteil, daß die Druckkante 27 des Rastschiebers 10 insbesondere für den Finger einer Bedienperson gut zugänglich ist, und eine nach unten gerichtete, zur Entriegelung des Hebelziehgriffes dienende Druckkraft problemlos aufgebracht werden kann. Schließlich kann auf der Vorderseite des langen Hebelarmes 3 ein Beschriftungsfeld 31 angebracht werden. Auf Grund der senkrecht stehenden Position des Hebelziehgriffes 1 in der Verriegelungsstellung ist eine im Beschriftungsfeld 31 plazierte Beschriftung jederzeit gut lesbar. Ferner steht auf Grund der bevorzugt linear gestreckten Bauform des Hebelziehgriffes 10 ein große Beschriftungsfläche zur Verfügung.

An Hand der Ausschnittdarstellung in Figur 4 durch einen Teil eines Hebelziehgriffs gemäß den Ausführungen der vorangegangenen Figuren, wird nachfolgend eine bevorzugten Ausführung einer Spiralfeder der Spannmittel des Frontsystems näher erläutert. Wie bereits dargestellt, verfügt die Spiralfeder 43 zumindest über einen Spannbogen 47, welche eine in Richtung des in Figur 4 dargestellten Doppelpfeiles gerichtete Spannkraft ausübt. Das eine Ende der Spiralfeder 43 ist vorteilhaft in Form einer u-förmigen Halteöse 44 ausgeführt. Durch Umspannung einer vorstehenden Halteleiste 45 am Endstück 11 durch die u-förmigen Halteöse 44 wird die Spiralfeder am Frontelement abgestützt. Das andere Ende der Spiralfeder 43 weist vorteilhaft die bereits beschriebene Form einer Druckschlaufe 35 auf. Diese greift vorteilhaft in die zweite Durchgriffsöffnung 28 am Fußende des Rastschiebers 10 ein und übt auf den zweiten Haltesteg 29 am unteren Ende der Durchgriffsöffnung 28 eine in Richtung des Druckpfeiles 52 orientierte Vorspannung aus. Diese bewirkt, daß der Rastschieber in Richtung 53 nach oben zum Griffbereich des Hebelziehgriffes vorgespannt wird.

Wie bereits in Figur 4 dargestellt ist, kann die Spiralfeder 43 vorteilhaft einen mit dem ersten Spannbogen 47 verbundenen zweiten Spannbogen 46 aufweist. Hierdurch kann in Richtung auf den weiteren, in Figur 4 dargestellten Doppelpfeil eine weitere, derart gerichtete Vorspannung auf den Hebelziehgriff 1 ausgeübt werden, daß dieser im entriegelten Zustand vom Frontelement weggeschwenkt wird. Wird der Rastschieber 10 folglich entgegen der Richtung der Pfeile 52,53 nach unten gedrückt, so tritt der Haltesteg 26 aus der Rastnut 23 aus und der Hebelziehgriff 1 kann ohne Behinderung durch den Rasthaken 22 in Richtung des Pfeiles 54 von der Frontplatte 56 selbsttätig wegschwenken. Diese selbsttätige Wegschwenkung wird durch den zweiten Spannbogen 46 in der Spiralfeder 43 bewirkt. Zur Bewirkung einer Art der Entkopplung der Wirkungen des ersten und des zweiten Spannbogens wird die Spannfeder annähernd im einem zwischen den Spannbögen liegenden Bereich über den Lagerzapfen 12 umgelenkt. Die Abstützung der Federmitte auf dem Lagerzapfen 12 bewirkt, daß die vom ersten Spannbogen 47 hervorgerufene Vorspannung im wesentlichen schiebend auf den Rastschieber 10 einwirkt, während die vom zweiten Spannbogen 46 hervorgerufene Vorspannung im wesentlichen drehend auf den Hebelziehgriff einwirkt.

über den In der Ausführungsform der Figur 4 weist der Federkörper zwischen erstem und zweitem Spannbogen 47,46 eine u-förmige Abdrückschlaufe 33 aus, welche so auf den entriegelten Hebelziehgriff eingreift, daß in Richtung auf die Pfeile 49,50 eine Drehbewegung um den als Drehpunkt wirkenden Lagerzapfen 12 auf den Hebelziehgriff ausgeübt wird. Der lange Hebelarm 3 und insbesondere der in Figur 4 nicht sichtbare Griffbereich 2 schwenken somit selbsttätig in Richtung des Pfeiles 54. Vorteilhaft umgreift die u-förmige Abdrückschlaufe 33 der Spiralfeder 43 einen zweiten Haltesteg 34, welcher die Durchgriffsöffnung 24 in der Front des Hebelziehgriffes nach unten begrenzt.

Bei einer weiteren, in Figur 1 bereits dargestellten Ausführungsform der Erfindung ist im Frontelement des Frontsystems zusätzlich ein elektrisches Schaltelement 18 derart integriert, daß dieses sich im verriegelten Zustand der Rastmittel in dem einen Schaltzustand, und im entriegelten Zustand der Rastmittel in dem anderen Schaltzustand befindet. Das integrierte Schaltelement 18 von Figur 1 ist bevorzugt in Form eines Mikroschalters ausgeführt. Dieser ist vorteilhaft über Bohrungen 19 mittels nicht dargestellter Montageschrauben an dem unteren Endstück 11 des Frontelements anbringbar. Ein Schaltbügel 20 wird bevorzugt über ein auf der Innenseite des langen Hebelarmes 3 des Hebelziehgriffes 1 angeordnetes, vorspringendes Schaltstück 42 betätigt, wenn sich der Hebelziehgriff senkrecht stehend in der Verriegelungsposition befindet. Auf der Rückseite des Schaltelements sind Anschlußkontakte 19, welche mit einer auf der Leiterplatte befindlichen Teilschaltung verbunden werden können. Mit einer derartigen Teilschaltung kann eine ordnungsgemäße Unterbrechung der Funktionen einer auf der Leiterplatte angeordneten Hauptschaltung bewirkt werden. Dies hat den Vorteil, daß die elektrischen Funktionen der Leiterplatte bereits dann ordnungsgemäß beendet werden können, wenn der Hebelziehgriff entriegelt wird, aber bevor die Leiterplatte durch weitere Aktivität der Hebelziehgriffe aus dem Baugruppenträger ausgehebelt und dabei zwangsläufig alle Steckkontakte zwischen Leiterplatte und Baugruppenträger unterbrochen werden.

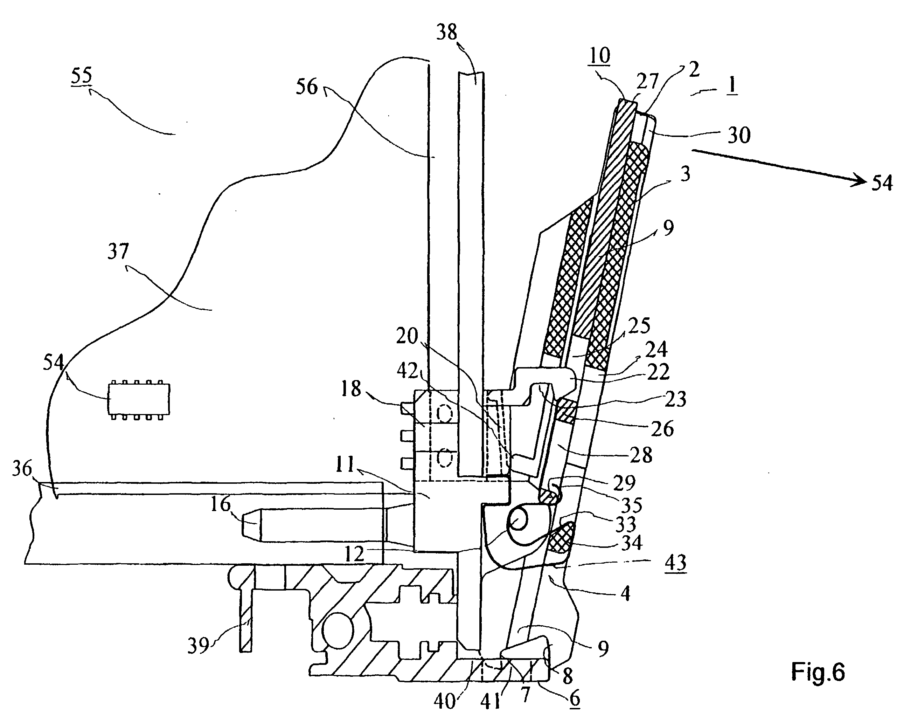

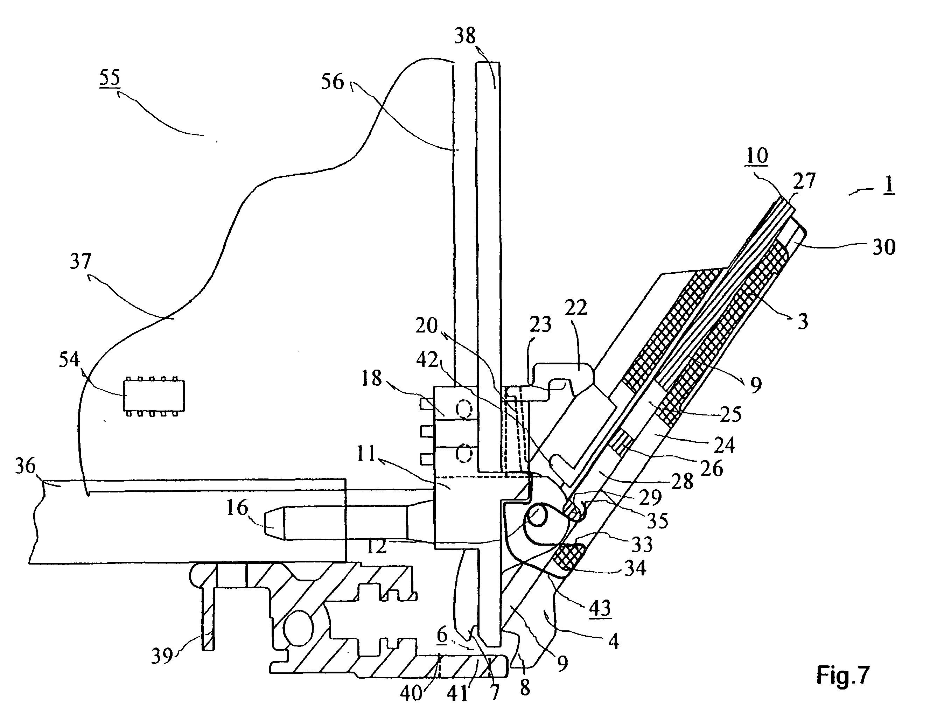

Das Frontsystem gemäß der Erfindung ist besonders geeignet für Frontelemente, in die zusätzlich ein quasi als ein Endschalter wirkendes Schaltelement 18 integriert ist. Dies wird abschließend mit Hilfe der Figuren 5, 6 und 7 näher erläutert. Dabei zeigt Figur 5 eine Schnittdarstellung durch einen am unteren Ende des Frontsystems 38,11 einer Leiterplatte 37 angebrachten Hebelziehgriff 1, wobei der Hebelziehgriff 1 sich in einer Verriegelungsstellung und die Leiterplatte 37 noch in dem vollständig in den Baugruppenträger 55 eingeschobenen Zustand befindet. Demgegenüber ist in der Figur 6 ein Zustand dargestellt, bei dem der Hebelziehgriff 1 sich in einer entriegelten Position, aber die Leiterplatte 37 in dem noch vollständig in den Baugruppenträger 55 eingeschobenen Zustand befindet. Schließlich zeigt Figur 7 einen Zustand, wobei der Hebelziehgriff 1 sich in einer entriegelten Stellung und die Leiterplatte 37 in dem aus dem Baugruppenträger 55 ausgeschobenen Zustand befindet.

Die Schnittdarstellung von Figur 5 zeigt beispielhaft die untere Querschiene 39 eines Paares aus einer unteren und einer oberen Querschiene eines Baugruppenträgers 55. Eine elektrische Leiterplatte 37, welche ein beispielhaft dargestelltes elektrisches Bauelement 54 trägt, ist an deren nach außen gerichteter Stirnseite 56 mit einem Frontelement versehen, welches bevorzugt eine Frontplatte 38 und untere und obere Eckstücke aufweist, wobei in Figur 1 beispielhaft das untere Eckstück 11 dargestellt ist. Bei der dargestellten Ausführungsform ist an der unteren, vorderen Ecke der Leiterplatte 37 das untere Eckstück 11 angebracht. Die Frontplatte 38 und der Hebelziehgriff 1 sind ebenfalls am unteren Eckstück gelagert. In aller Regel ist ein weiterer, in den Figuren nicht dargestellter Hebelziehgriff am oberen Eckstück des Frontelements angebracht. Die Leiterplatte 37 ist über die unteren und oberen Kanten in einem gegenüberliegenden Paar von Führungsschienen bevorzugt senkrecht stehend im Baugruppenträger 55 angeordnet. Dabei ist im Ausschnitt der Figur 5 beispielhaft die untere Führungsschiene 36 dargestellt. Mit Hilfe des Hebelziehgriffes 1 kann die Leiterplatte in den Baugruppenträger eingeschoben bzw. wieder ausgeschoben werden.

In Figur 1 befindet sich der Hebelziehgriff 1 in der Verriegelungsstellung und liegt somit senkrecht stehend möglichst nahe an der Stirnseite 56 der Leiterplatte bzw. der Frontplatte 38 an. Da die Leiterplatte vollständig in den Baugruppenträger 55 eingeschoben ist, muß die Funktion der darauf befindlichen elektrischen Schaltung freigegeben sein. Hierzu greift der Hebelziehgriff 1 bevorzugt über das vorspringende Schaltstück 42 so auf den Schaltbügel 20 des Schaltelementes 18 ein, daß dieses sich in dem, die Schaltung freigebenden Schaltzustand befindet. Wie bereits erläutert, wird der Hebelziehgriff 1 durch Eingriff der Rastnase 22 auf den Rastschieber 10 in der dargestellten Verriegelungsstellung gehalten.

Soll nun die Leiterplatte z.B. zu Prüfzwecken aus dem Baugruppenträger entnommen werden, so muß zunächst der Hebelziehgriff 1 entriegelt werden. Wie oben bereits erläutert, muß hierzu von einem Bediener eine auf den maulschlüsselartigen Eingriffsbereich 6 des Hebelziehgriffes gegen die Vorspannung der Spannmittel gerichtete Druckkraft so auf die Druckkante 27 des Rastschiebers 10 ausgeübt werden, daß der Rastschieber 10 aus dem Eingriffsbereich der Rastnase 20 kommt. Verfügen die insbesondere in Form der Spiralfeder ausgeführten Spannmittel über einen zweiten Spannbogen, so schwenkt der Hebelziehgriff selbsttätig aus der Verriegelungsposition und nimmt die in Figur 6 dargestellte Stellung ein. Durch diese Vorschwenkung wird zum einen der Eingriffsbereich 6 in den aktiven Zustand gebracht, in dem sich die Aushebelkante 8 an die Stirnseite der Abstützleiste 40 anlegt. Zum anderen wird der Schaltbügel 20 des Schaltelements 18 so entlastet, daß das Schaltelement des anderen Schaltzustand einnimmt. Dieser wird in aller Regel dazu benutzt, die elektrischen Funktionen auf der Leiterplatte in einer ordnungsgemäßen Weise zu beenden.

Soll nun die Leiterplatte vollständig ausgehebelt werden, so muß in der in Figur 6 dargestellten Position nun ein ausreichend großer Kraftaufwand auf den abgespreizten und somit für die Hand einer Bedienperson vollständig zugänglichen Griffbereich 2 des Hebelziehgriffes ausgeübt werden. Durch Abstützung der Aushebelkante 8 an der unteren Querschiene 39 wird die Leiterplatte aus nicht dargestellten Steckverbindern gezogen und nimmt dann z.B. die in Figur 7 dargestellte Position ein. Der Hebelziehgriff ist nun vollständig nach vorne weggeschwenkt, da die Elemente von dessen Eingriffsbereich 6 in keinem Kontakt zu den Eingriffsöffnungen 41 in der unteren Querschiene 39 stehen. Die Leiterplatte 37 kann nun vollständig aus der Führungsschiene 36 gezogen und aus dem Baugruppenträger 55 entnommen werden.

An Hand des in Figuren 5, 6 und 7 dargestellten Bewegungsablaufes, der bei einer Aushebelung einer Leiterplatte auftritt, sind die Vorteile der erfindungsgemäßen Frontsystems besonders deutlich zu erkennen. Diese werden insbesondere darin gesehen, daß die zur Entriegelung des Hebelziehgriffes einerseits und die zum Aushebeln der Leiterplatte andererseits notwendigen Kraftaufwendungen auf den Hebelziehgriff und die dadurch hervorgerufenen Bewegungsabläufe so voneinander entkoppelt sind, daß ein versehentlicher, quasi schleichender Übergang zwischen den beiden Vorgängen mit Sicherheit vermieden wird.

## Patentansprüche

1. Frontsystem für elektrische Leiterplatten (37), die über gegenüberliegenden Paaren von nebeneinander angeordneten Führungsschienen (36) bevorzugt senkrecht stehend in einen Baugruppenträger (55) ein- und ausschiebbar sind, wobei
a) ein Frontelement (38,11) an der frontseitigen Stirnseite (56) einer Leiterplatte (37) angebracht ist,
b) je ein Hebelziehgriff (1) an der oberen bzw. unteren Ecke des Frontelements (38,11) angebracht, über einen Drehpunkt (5,12) in der Ebene der Leiterplatte (37) schwenkbar gelagert ist und an dem der jeweiligen Ecke des Frontelements zugewandten Ende einen Eingriffsbereich (6) aufweist, worüber durch Abstützung am Baugruppenträger (55) eine Einbzw. Aushebelung der Leiterplatte in den bzw. aus dem Baugruppenträger (55) bewirkbar ist,
c) je ein Rastschieber (10) in einem Hebelziehgriff (1) gelagert ist, welcher an dem Ende eines Hebelziehgriffes (1) einen Druckbereich (27) aufweist, der dem Eingriffsbereich (6) gegenüberliegt,
d) Spannmittel (43,32,28,29,35) vorhanden sind, welche eine auf den einen Druckbereich (27) gerichtete Vorspannung (52,53) auf den Rastschieber (10) ausüben und diesen in einer Ausgangsposition halten, und
e) Rastmittel (22,23,26) vorhanden sind, welche an der oberen bzw. unteren Ecke des Frontelements (38,11) angeordnet sind und bei einer auf das Frontelement (38,11) der Leiterplatte (37) gerichteten Schwenkung des Hebelziehgriffes (1) so auf den Rastschieber (10), die Spannmittel (43,32,28,29,35) und das Frontelement (38,11) eingreifen, daß der Hebelziehgriff (1) möglichst am Frontelement (38,11) anliegend in einer Verriegelungsstellung gehalten wird, und die Rastmittel (22,23,26) durch eine auf den Druckbereich (27) des Rastschiebers (10) des Hebelziehgriffes (1) ausgeübte und gegen die Vorspannung (52,53) der Spannmittel (22,23,26) gerichtete Verschiebung des Rastschiebers (10) wieder entriegelbar sind.

2. Frontsystem nach Anspruch 1, wobei die Rastmittel (22,23,26) einen Rasthaken (22) aufweisen, welcher derart ausgebildet ist, daß mittels der durch die Spannmittel (43,32,28,29,35) auf den Rastschieber (10) ausgeübten Vorspannung (52,53) der Rastschieber (10) und das Frontelement (38,11) so miteinander in Eingriff kommen, daß der Hebelziehgriff (1) in der Verriegelungsposition gehalten wird.

3. Frontsystem nach Anspruch 1 oder 2, wobei
a) das Frontelement (38,11) einer Leiterplatte (37) eine Frontplatte (38) und je ein Endstück (11) am unteren und oberen Ende der Frontplatte (38) aufweist, worüber die Frontplatte (38) mit der Leiterplatte (37) verbunden ist, und
b) die Rastmittel (22,23,26) mit dem Endstück (11) am jeweiligen Ende der Frontplatte (38) verbunden sind.

4. Frontsystem nach Anspruch 3, wobei der Rastschieber (10) zumindest eine Durchgriffsöffnung (25) aufweist, bei der ein Wandungsbereich (26) mittels der durch die Spannmittel (43,32,28,29,35) auf den Rastschieber (10) ausgeübten Vorspannung (52,53) mit den Rastmitteln (22) in Eingriff kommt.

5. Frontsystem nach einem der vorangegangenen Ansprüche, wobei an demjenigen Ende eines Hebelziehgriffes (1), welcher dem Eingriffsbereich (6) gegenüberliegt, eine bevorzugt halbmondförmige Griffmulde (30) vorhanden ist, in welcher der Druckbereich (27) des Rastschiebers (10) liegt.

6. Frontsystem nach einem der vorangegangenen Ansprüche, wobei die Spannmittel (43,32,28,29,35) eine Spiralfeder (43) aufweisen, welche
a) zumindest über einen ersten Spannbogen (47) verfügt, wodurch die auf den Druckbereich (27) des Rastschiebers (10) gerichtete Vorspannung (52,53) ausgeübt wird, und
b) der erste Spannbogen (47) am Frontelement (38,11) abgestützt ist.

7. Frontsystem nach Anspruch 6, wobei die Spiralfeder (43) einen mit dem ersten Spannbogen (47) verbundenen zweiten Spannbogen (46) aufweist, wodurch auf den Hebelziehgriff (1) eine weitere, derart gerichtete Vorspannung (54) ausgeübt wird, daß dieser im entriegelten Zustand vom Frontelement (38,11) weggeschwenkt wird.

8. Frontsystem nach einem der vorangegangenen Ansprüche, wobei im Frontelement (38,11) ein elektrisches Schaltelement (18,19) derart integriert ist, daß dieses sich im verriegelten Zustand der Rastmittel (22,23,26) in dem einen Schaltzustand, und im entriegelten Zustand der Rastmittel (22,23,26) in dem anderen Schaltzustand befindet.

9. Frontsystem nach einem der vorangegangenen Ansprüche, wobei der Hebelziehgriff (1) derart gesteckt ist, daß dieser in der Verriegelungsstellung der Rastmittel (22,23,26) annähernd parallel zum Frontelement (38,11) der Leiterplatte verläuft und an dieser möglichst flach anliegt.

10. Frontsystem nach Anspruch 9, wobei der Hebelziehgriff (1) zumindest einen ersten, geradlinig gestreckten langen Hebelarm (3) aufweist, in dem der Rastschieber (10) gelagert ist und an dessen Ende des Druckbereiches (27) des Rastschiebers (10) liegt.

## Claims

1. Front system for electrical printed circuit boards (37), which can be inserted into a mounting rack (55) and can be pulled out from it via opposite pairs of guide rails (36) which are arranged alongside one another and are preferably vertical, with
a) a front element (38, 11) being fitted to the front end face (56) of a printed circuit board (37),
b) in each case one lever pulling handle (1) being fitted to the upper and lower corner, respectively, of the front element (38, 11), being mounted such that it can pivot via a rotation point (5, 12) in the plane of the printed circuit board (37) and having an engagement region (6) at the end facing the respective corner of the front element, via which, by being supported on the mounting rack (55), the printed circuit board can be levered into and out of the mounting rack (55),
c) in each case one latching slide (10) being mounted in a lever pulling handle (1), which has a pushing region (27) which is opposite the engagement region (6) at the end of a lever pulling handle (1),
d) tensioning means (43, 32, 28, 29, 35) being provided, which exert a prestress (52, 53) in the direction of the one pushing region (27) on the latching slide (10) and hold the latter in an initial position, and
e) latching means (22, 23, 26) being provided, which are arranged at the upper and lower corner of the front element (38, 11) and, when the lever pulling handle (1) is pivoted in the direction of the front element (38, 11) of the printed circuit board (37), engage on the latching slide (10), the tensioning means (43, 22, 28, 29, 35) and the front element (38, 11) such that the lever pulling handle (1) is held as far as possible resting in a locked position on the front element (38, 11), and the latching means (22, 23, 26) can be unlocked again by moving the latching slide (10) in the opposite direction to the prestress (52, 53) of the tensioning means (22, 23, 26), with said movement being exerted onto the pushing region (27) of the latching slide (10) of the lever pulling handle (1).

2. Front system according to Claim 1, with the latching means (22, 23, 26) having a latching hook (22) which is designed such that, by means of the prestress (52, 53) which is exerted on the latching slide (10) by the tensioning means (43, 32, 28, 29, 35), the latching slide (10) and the front element (38, 11) can be engaged with one another such that the lever pulling handle (1) is held in the locked position.

3. Front system according to Claim 1 or 2, in which
a) the front element (38, 11) of a printed circuit board (37) has a front panel (38) and in each case one end piece (11) at the lower and upper ends of the front panel (38), via which the front panel (38) is connected to the printed circuit board (37), and
b) the latching means (22, 23, 26) are connected to the end piece (11) at the respective end of the front panel (38).

4. Front system according to Claim 3, in which the latching slide (10) has at least one through-opening (25), in which a wall region (26) engages with the latching means (22) by means of the prestress (52, 53) which is exerted on the latching slide (10) by means of the tensioning means (43, 32, 28, 29, 35).

5. Front system according to one of the preceding claims, in which, at that end of a lever pulling handle (1) which is opposite the engagement region (6), there is a preferably half-moon-shaped gripping recess (30), in which the pushing region (27) of the latching slide (10) is located.

6. Front system according to one of the preceding claims, in which the tensioning means (43, 32, 28, 29, 35) have a spiral spring (43) which
a) has at least one first tensioning curve (47) which is used to exert the prestress (52, 53) in the direction of the pushing region (27) of the latching slide (10), and
b) the first tensioning curve (47) is supported on the front element (38, 11).

7. Front system according to Claim 6, in which the spiral spring (43) has a second tensioning curve (46), which is connected to the first tensioning curve (47), by means of which a further prestress (54) is exerted on the lever pulling handle (1), in such a direction that the lever pulling handle (1) is pivoted away from the front element (38, 11) in the unlocked state.

8. Front system according to one of the preceding claims, in which an electrical switching element (18, 19) is integrated in the front element (38, 11) such that, when the latching means (22, 23, 26) are in the locked state, this electrical switching element (18, 19) is located in the one switching state, and, when the latching means (22, 23, 26) are in the unlocked state, it is in the other switching state.

9. Front system according to one of the preceding claims, in which the lever pulling handle (1) is inserted such that, when the latching means (22, 23, 26) are in the locked position, this lever pulling handle (1) runs approximately parallel to the front element (38, 11) of the printed circuit board, and rests as flat as possible on it.

10. Front system according to Claim 9, in which the lever pulling handle (1) has at least one first, long lever arm (3), which extends in a straight line and in which the latching slide (10) is mounted and at whose end the pushing region (27) of the latching slide (10) is located.

## Revendications

1. Système frontal pour cartes de circuit imprimé (37) qui peuvent être insérées et extraites par coulissement dans un support de module (55), de préférence en position verticale, par des paires opposées de rails de guidage (36) disposées l'une à côté de l'autre, dans lequel
a) un élément frontal (38, 11) est installé sur le côté frontal (56) d'une plaque de circuit imprimé (37),
b) une poignée (1) de traction de levier installée chaque fois sur le coin supérieur et sur le coin inférieur de l'élément frontal (38, 11), montée à pivotement autour d'un centre de rotation (5, 12) situé dans le plan de la plaque de circuit imprimé (37) présente une zone d'engagement (6) à l'extrémité tournée vers le coin correspondant de l'élément frontal, par l'intermédiaire de laquelle, par appui sur le support de module (55), la plaque de circuit imprimé peut être basculée dans ou hors du support de module (55),
c) une glissière d'accrochage élastique (10) est chaque fois montée dans une poignée (1) de traction de levier et présente à l'extrémité d'une poignée (1) de traction de levier une zone de poussée (27) située en face de la zone d'engagement (6),
d) des moyens de serrage (43, 32, 28, 29, 35) sont prévus et exercent sur la glissière d'accrochage élastique (10) une précontrainte (52, 53) dirigée vers l'une des zones de poussée (27) et maintiennent la glissière d'accrochage élastique dans une position de départ,
e) des moyens d'accrochage élastique (22, 23, 26) sont prévus et sont disposés sur le coin supérieur et sur le coin inférieur de l'élément frontal (38, 11), et lors d'un pivotement de la poignée (1) de traction de levier dirigé vers l'élément frontal (38, 11) de la plaque à circuit imprimé (37), les moyens de serrage (43, 32, 28, 29, 35) et l'élément frontal (38, 11) s'engagent sur la glissière d'accrochage élastique (10) de telle sorte que la poignée (1) de traction de levier est maintenue dans une position de verrouillage reposant le plus près possible de l'élément frontal (38, 11), et les moyens d'accrochage élastique (22, 23, 26) peuvent de nouveau être déverrouillés par un coulissement de la glissière d'accrochage élastique (10) imprimé par la zone de poussée (27) de la glissière d'accrochage élastique (10) de la poignée (1) de traction de levier orienté en opposition à la précontrainte (52, 53) des moyens de serrage (22, 23, 26).

2. Système frontal selon la revendication 1, dans lequel les moyens d'accrochage élastique (22, 23, 26) présentent un crochet d'accrochage élastique (22) qui est configuré de telle sorte qu'au moyen de la précontrainte (52, 53) exercée par les moyens de serrage (43, 32, 28, 29, 35) sur la glissière d'accrochage élastique (10), la glissière élastique (10) et l'élément frontal (38, 11) s'engagent l'une dans l'autre de telle sorte que la poignée (1) de traction de levier est maintenue dans la position de verrouillage.

3. Système frontal selon la revendication 1 ou 2, dans lequel
a) l'élément frontal (38, 11) d'une plaque de circuit imprimé (37) présente une plaque de circuit imprimé (38) et chaque fois une pièce d'extrémité (11) à l'extrémité inférieure et à l'extrémité supérieure de la plaque frontale (38), par l'intermédiaire desquelles la plaque frontale (38) est reliée à la plaque de circuit imprimé (37), et
b) les moyens d'accrochage élastique (22, 23, 26) sont reliés à la pièce d'extrémité (11) à chaque extrémité de la plaque frontale (38).

4. Système frontal selon la revendication 3, dans lequel la glissière d'accrochage élastique (10) présente au moins une ouverture de traversée (25) par laquelle une zone de paroi (26) s'engage sur les moyens d'accrochage élastique (22) au moyen de la précontrainte (52, 53) exercée par les moyens de serrage (43, 32, 28, 29, 35) sur la glissière d'accrochage élastique (10).

5. Système frontal selon l'une des revendications précédentes, dans lequel à chaque extrémité d'une poignée (1) de traction de levier opposée à la zone d'engagement (6) se trouve une moulure de saisie (30), de préférence en forme de demi lune, dans laquelle est située la zone de poussée (27) de la glissière d'accrochage élastique (10).

6. Système frontal selon l'une des revendications précédentes, dans lequel les moyens de serrage (43, 32, 28, 29, 35) présentent un ressort hélicoïdal (43)
a) qui dispose d'au moins un premier étrier de serrage (47) par lequel est exercée la précontrainte (52, 53) dirigée sur la zone de poussée (27) de la glissière d'accrochage élastique (10),
b) le premier étrier de serrage (47) étant appuyé sur l'élément frontal (38, 11).

7. Système frontal selon la revendication 6, dans lequel le ressort hélicoïdal (43) présente un deuxième étrier de serrage (46) relié au premier étrier de serrage (47) et par lequel une autre précontrainte (54) dirigée sur la poignée (1) de traction de levier est exercée de telle sorte que cette poignée est éloignée de l'élément frontal (38, 11) par basculement dans la position déverrouillée.

8. Système frontal selon l'une des revendications précédentes, dans lequel un élément de commutation électrique (18, 19) est intégré dans l'élément frontal (38, 11) de telle sorte que lorsque les moyens d'accrochage élastique (22, 23, 26) se trouvent en position verrouillée, l'élément de commutation se trouve dans l'une des positions de commutation et que lorsque les moyens d'accrochage élastique (22, 23, 26) se trouvent en position déverrouillée, l'élément de commutation se trouve dans l'autre position de commutation.

9. Système frontal selon l'une des revendications précédentes, dans lequel la poignée (1) de traction de levier est enfichée de telle sorte que lorsque les moyens d'accrochage élastique (22, 23, 26) se trouvent dans la position de verrouillage, elle s'étend sensiblement en parallèle à l'élément frontal (38, 11) de la plaque de circuit imprimé et repose sur cette dernière par une surface aussi grande que possible.

10. Système frontal selon la revendication 9, dans lequel la poignée (1) de traction de levier présente au moins un premier long bras de levier (3) étiré en ligne droite dans lequel est montée la glissière d'accrochage élastique (10) et à l'extrémité de la zone de poussée (27) de laquelle se trouve la glissière d'accrochage élastique (10).
